(19) Europäisches Patentamt
European Patent Office
Office européen des brevets

(11) **EP 1 061 644 A1**

(12) **DEMANDE DE BREVET EUROPEEN**

(43) Date de publication:
**20.12.2000 Bulletin 2000/51**

(51) Int. Cl.$^7$: **H03G 5/00**, H03F 1/32

(21) Numéro de dépôt: **00202010.5**

(22) Date de dépôt: **07.06.2000**

(84) Etats contractants désignés:
**AT BE CH CY DE DK ES FI FR GB GR IE IT LI LU MC NL PT SE**
Etats d'extension désignés:
**AL LT LV MK RO SI**

(30) Priorité: **15.06.1999 FR 9907560**

(71) Demandeur:
**Koninklijke Philips Electronics N.V.**
**5621 BA Eindhoven (NL)**

(72) Inventeur: **Legendre, Michel**
**75008 Paris (FR)**

(74) Mandataire:
**de la Fouchardière, Marie-Noelle**
**Société Civile "SPID"**
**156, Boulevard Haussmann**
**75008 Paris (FR)**

(54) **Amplificateur destiné a un réseau de distribution**

(57) Amplificateur destiné à un réseau de distribution de signaux, comprenant des moyens de filtrage pour donner une pente positive à la courbe (N, $L_{in}$ , K) du gain de l'amplificateur en fonction de la fréquence. Les moyens de filtrage produisent une courbe (N) qui répond à la formule :

$$L \, (dB\mu V) = K *(F)^{3/2}$$

dans laquelle "L" est le niveau de signal de sortie, "F" la fréquence, et "K" un coefficient de proportionnalité.

Applications : CATV, MATV

FIG.3

**Description**

La présente invention concerne un amplificateur destiné à un réseau de distribution de signaux, pour amplifier ces signaux dans une gamme de fréquences prédéterminée, amplificateur comprenant des moyens pour donner une pente positive à la courbe qui représente le gain de l'amplificateur en fonction de la fréquence.

Elle concerne en outre un réseau de distribution de signaux.

Un amplificateur destiné à un réseau de distribution de signaux, selon le préambule ci-dessus, est connu de la demande de brevet EP-A-0 206 557. Selon ce document, un égaliseur corrige la pente dans le signal, pente due à la caractéristique d'atténuation du câble en fonction de la fréquence.

Un objet de l'invention est d'atténuer les signaux d'intermodulation (dits "CSO" ou "CTB") créés par l'amplificateur ou, ce qui revient au même, d'augmenter la puissance de sortie que l'amplificateur peut délivrer pour une distorsion donnée.

A cet effet, les dits moyens donnent à la courbe une pente qui, comparée à la pente, appelée linéaire, obtenue dans le cas d'une croissance régulière avec la fréquence, est plus faible que la pente linéaire dans le bas de la gamme de fréquence, puis plus grande dans le haut de cette gamme.

Comme l'indique le document cité, on sait que les câbles apportent une atténuation croissante avec la fréquence, et il était naturel de chercher à compenser cette atténuation, ce qui conduisait à choisir dans le bas de la gamme de fréquence une pente plus grande que la pente linéaire, puis une pente plus faible dans le haut de cette gamme ; cette forme de courbe compense exactement l'atténuation du câble. L'invention repose sur la constatation qu'en fait, pour obtenir les meilleurs résultats, il faut choisir une pente différente de celle qui compense l'atténuation du câble.

Avantageusement, la courbe représentant le gain de l'amplificateur par rapport à la fréquence, produite par les dits moyens, répond à la formule : $L\,(dB\mu V) = K * (F)^{3/2}$, dans laquelle "L" est le niveau de signal, "F" la fréquence, et "K" un coefficient de proportionnalité.

Un réseau de distribution de signaux comprend avantageusement au moins un amplificateur comprenant des moyens comme définis ci-dessus.

Ces aspects de l'invention ainsi que d'autres aspects plus détaillés apparaîtront plus clairement grâce à la description suivante d'un mode de réalisation constituant un exemple non limitatif.

La figure 1 représente schématiquement un réseau de distribution de signaux, ici un réseau de distribution de télévision.

La figure 2 est un diagramme niveau / fréquence illustrant l'amplitude de canaux de télévision répartis entre les fréquences extrêmes 47 MHz et 860 MHz.

La figure 3 illustre plusieurs types de courbes de niveau de signal fourni par un amplificateur, en fonction de la fréquence.

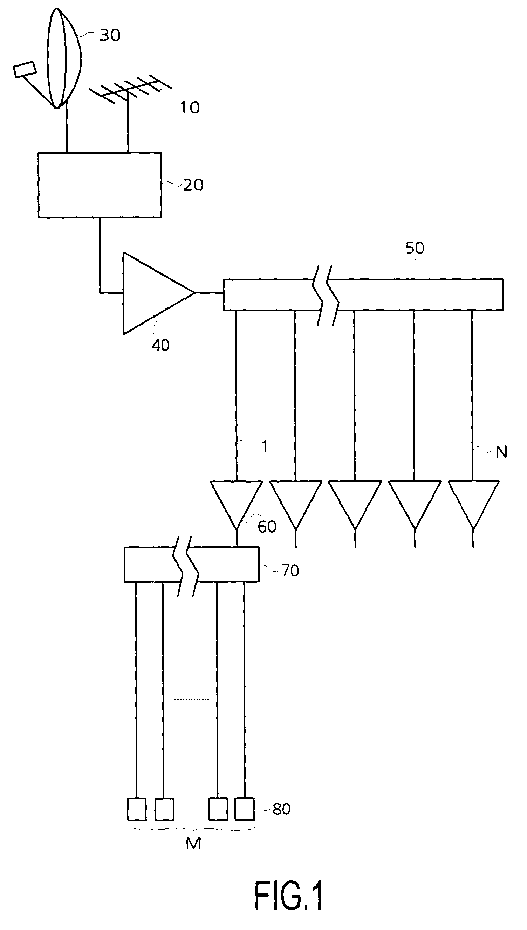

Dans le réseau de la figure 1, un système d'antenne comprend une parabole 30, pour la réception par satellite, parabole au foyer de laquelle se trouve un convertisseur de réception traditionnel, et une antenne dite "terrestre" 10. Les signaux provenant de ces deux sources sont mélangés, d'une manière qui ne fait pas partie de l'invention, dans un module 20 qui fournit des signaux dans une gamme de fréquences à un amplificateur 40. Un répartiteur 50 amène sur chacun de N câbles 1 à N l'ensemble des signaux mélangés issus du module 20. A leur tour ces câbles délivrent des signaux, amplifiés par des amplificateurs dont l'un est référencé 60, à des répartiteurs 70, dont un seul est représenté pour ne pas encombrer la figure. Un répartiteur 70 délivre les signaux à chacune des M prises 80 desservant chacune un usager. Le nombre de prises qu'il est possible d'installer en garantissant une qualité de signal donnée sur chaque prise est une mesure de l'efficacité du réseau.

Ce réseau est décrit à titre d'exemple ; un amplificateur de l'invention peut être situé dans toute application dite "CATV" ou "MATV" mettant en oeuvre des câbles de liaison, par exemple aussi dans l'étage de sortie d'une liaison optique.

L'amplificateur 40 et/ou les amplificateurs 60 comprennent des moyens, par exemple des filtres, pour donner une pente positive à la courbe qui représente le gain ou le niveau de sortie de l'amplificateur en fonction de la fréquence.

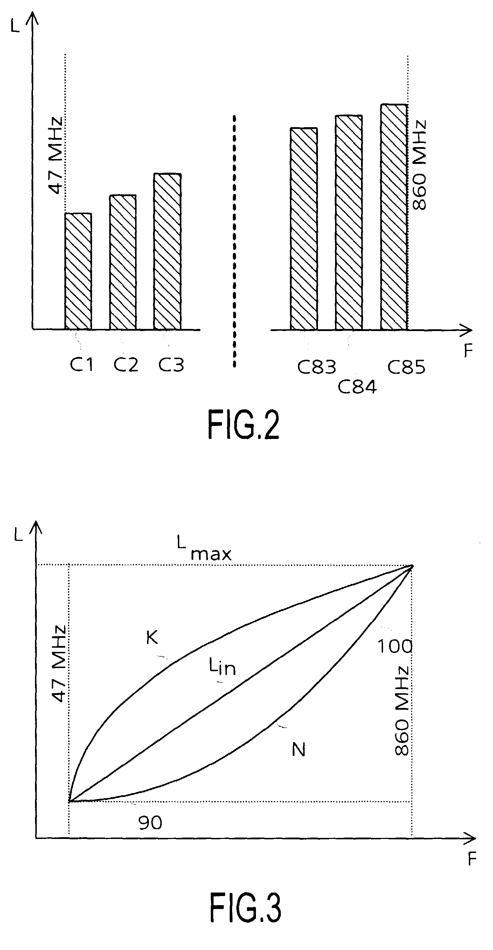

Sur la figure 2, des canaux numérotés C1 à C85 sont représentés, dans une gamme de fréquences allant de 47 à 860 MHz. L'amplitude de ces canaux augmente en allant des fréquences les plus basses vers les fréquences les plus hautes.

La figure 3 illustre avec plus de précision la forme de différents types de courbes de niveau de signal fourni par un amplificateur, en fonction de la fréquence. Une courbe représente les positions des points centraux les plus hauts des canaux de la figure 2. Pour faciliter les comparaisons, toutes les courbes se terminent du côté des fréquences les plus élevées au même niveau maximal $L_{max}$.

La courbe $L_{in}$ est la pente dite linéaire obtenue dans le cas d'une croissance régulière avec la fréquence.

La courbe K est la courbe connue, qui correspond à la compensation exacte de la caractéristique d'atténuation du câble en fonction de la fréquence. Une telle courbe répond en théorie à la fonction $L\,(dB\mu V) = K * \sqrt{F}$

La courbe N est celle qu'il convient d'obtenir selon l'invention. Sa pente, comparée à celle de la

courbe $L_{in}$, est plus faible en 90 dans le bas de la gamme de fréquence, puis plus grande dans le haut 100 de cette gamme.

De préférence, la courbe N de la figure 3 représente la fonction :

$$L\ (dB\mu V) = K\ ^*(F)^{3/2}$$

dans laquelle "L" est le niveau de signal délivré (en dBµV), "F" est la fréquence, et "K" est un coefficient de proportionnalité.

Une telle courbe peut être obtenue par tout moyen connu, par exemple au moyen de filtres en T ponté, ou par un dispositif appelé "égaliseur", tel que celui mentionné dans le document cité.

Un amplificateur selon l'invention permet, par exemple dans le cas de la mesure dite "60 PAL VHF" + signaux QAM64 jusqu'à 860 Mhz, d'alimenter un nombre de prises près de 15% supérieur à celui obtenu dans l'art antérieur, ce qui signifie 15% d'économie sur le coût du système.

Il doit être clair que le verbe "comprendre" n'exclut pas la présence d'autres éléments ou étapes que celles listées dans une revendication.

**Revendications**

1. Amplificateur destiné à un réseau de distribution de signaux, pour amplifier ces signaux dans une gamme de fréquences prédéterminée, amplificateur comprenant des moyens pour donner une pente positive à la courbe qui représente le gain de l'amplificateur en fonction de la fréquence, **caractérisé en ce que** les dits moyens donnent à la courbe une pente qui, comparée à la pente, appelée linéaire, obtenue dans le cas d'une croissance régulière avec la fréquence, est plus faible que la pente linéaire dans le bas de la gamme de fréquence, puis plus grande dans le haut de cette gamme.

2. Amplificateur destiné à un réseau de distribution de signaux, selon la revendication 1, **caractérisé en ce que** la courbe représentant le gain de l'amplificateur par rapport à la fréquence, produite par les dits moyens , répond à la formule : $L\ (dB\mu V) = K^*\ (F)^{3/2}$ , dans laquelle "L" est le niveau de signal, "F" la fréquence, et "K" un coefficient de proportionnalité.

3. Réseau de distribution de signaux, **caractérisé en ce qu'**il comprend au moins un amplificateur muni de moyens selon la revendication 1.

4. Réseau de distribution de signaux, **caractérisé en ce qu'**il comprend au moins un amplificateur muni de moyens selon la revendication 2.

FIG.1

FIG.2

FIG.3

Office européen
des brevets

**RAPPORT DE RECHERCHE EUROPEENNE**

Numéro de la demande

EP 00 20 2010

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| Y | US 4 600 847 A (BAUM PETER N) 15 juillet 1986 (1986-07-15) * le document en entier * --- | 1,3 | H03G5/00 H03F1/32 |
| Y | ALBERTY M ET AL: "EMPFANGSUNTERSYSTEME IM KU-BAND UND KA-BAND FUER ERD-FUNKSTELLEN DES DFS KOPERNIKUS" NACHRICHTENTECHNISCHE BERICHTE,DE,ANT NACHRICHTENTECHNIK GMB. BACKNANG, no. 7, 1 octobre 1990 (1990-10-01), pages 110-118, XP000234676 * page 110 - page 115; figures 1-9 * --- | 1,3 | |
| A | EP 0 486 953 A (GTE LABORATORIES INC) 27 mai 1992 (1992-05-27) * page 2, ligne 1 - page 4, ligne 55; figures 1-3 * --- | 1,2 | |
| A | US 5 798 854 A (REGEHR MARTIN ET AL) 25 août 1998 (1998-08-25) * abrégé; figures 1,6 * --- | 1 | DOMAINES TECHNIQUES RECHERCHES (Int.Cl.7) |
| A | EP 0 792 069 A (GEN INSTRUMENT CORP) 27 août 1997 (1997-08-27) * abrégé; figures 1,2 * ----- | 1 | H03G H03F |

Le présent rapport a été établi pour toutes les revendications

| Lieu de la recherche | Date d'achèvement de la recherche | Examinateur |
|---|---|---|
| LA HAYE | 21 septembre 2000 | Tyberghien, G |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
 
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 00 20 2010

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

21-09-2000

| Document brevet cité au rapport de recherche | | Date de publication | Membre(s) de la famille de brevet(s) | | Date de publication |
|---|---|---|---|---|---|
| US 4600847 | A | 15-07-1986 | AUCUN | | |
| EP 0486953 | A | 27-05-1992 | US | 5119392 A | 02-06-1992 |
| | | | CA | 2055723 A | 22-05-1992 |
| | | | JP | 4267574 A | 24-09-1992 |
| US 5798854 | A | 25-08-1998 | AU | 708748 B | 12-08-1999 |
| | | | AU | 2641895 A | 18-12-1995 |
| | | | CN | 1151229 A | 04-06-1997 |
| | | | EP | 0760184 A | 05-03-1997 |
| | | | JP | 10500824 T | 20-01-1998 |
| | | | WO | 9532561 A | 30-11-1995 |
| EP 0792069 | A | 27-08-1997 | US | 5699179 A | 16-12-1997 |

EPO FORM P0460

Pour tout renseignement concernant cette annexe : voir Journal Officiel de l'Office européen des brevets, No.12/82